# EUROPEAN PATENT APPLICATION

(11) **EP 1 835 006 A1**
(43) Date of publication of application: **19.09.2007**
(21) Application number: 05842263.5
(22) Date of filing: 26.12.2005
(51) Int. Cl.: C09K 11/06

(54) **ORGANIC ELECTROLUMINESCENCE ELEMENT**

(30) Priority: 05.01.2005 JP 2005000567
(71) Applicant: IDEMITSU KOSAN CO., LTD., Tokyo 100-8321 (JP)
(72) Inventor: KONDO, Hirofumi, 2990293 (JP); INOUE, Tetsuya, 2990293 (JP); KAWAMURA, Hisayuki, 2990293 (JP)
(74) Representative: Gille Hrabal Struck Neidlein Prop Roos
(86) International application number: PCT/JP2005/023721
(87) International publication number: WO 2006/073072

(57) **Abstract**

An organic electroluminescent device including: an anode (10), a hole injecting/transporting layer (22), an emitting layer (24) and a cathode (30) stacked in this order; the emitting layer (24) being a low molecular emitting layer formed by a wet process using a low molecular luminescent material; the hole injecting/transporting layer (22) being a high molecular hole injecting/transporting layer formed by a wet process using a high molecular material.

## Description

### TECHNICAL FIELD

The invention relates to an organic electroluminescent device, in particular, to an organic electroluminescent device wherein a hole injecting/transporting layer and an emitting layer are formed by a wet process, the hole injecting/transporting layer is formed of a high molecular material, and the emitting layer is formed of a low molecular luminescent material.

### BACKGROUND

A display element having a high performance is required as the development of the information and communication industry is accelerated. Attention is paid to an organic electroluminescent device (hereinafter "electroluminescent" is abbreviated as "EL") as a next generation display element under such circumstances.
An organic EL device is a self-emission type display element which has advantages of not only a wide view angle and an excellent contrast, but also a short response time.

An organic thin layer including an emitting layer is formed by a dry process such as vacuum deposition, or a wet process such as spin coating and inkjet.
The dry process has advantages that it is unnecessary to dissolve a material constituting the organic thin layer in a solvent and it is unnecessary to remove the solvent after forming the layer. Since the vacuum deposition is a high vacuum process requiring large equipment, the vacuum deposition has disadvantages that the production cost is expensive, it cannot be applied to a large-screen substrate, and mass-production is difficult.
On the other hand, the wet process is relatively easily applied to an enlarged screen easily. However, the wet process can not be applied to a material insoluble in a solvent.

Therefore, for example, an emitting layer is generally formed by a dry process with the exception that the emitting layer is formed by a wet process using a high molecular material such as a soluble PPV (poly(p-phenylenevinylene)) into which a functional group is introduced to improve solubility properties for an organic solvent.
As examples of an organic EL device with a plurality of organic thin layers that is formed by a wet process, there is disclosed an organic EL device formed by spin coating wherein both a hole injecting layer and an emitting layer are formed of a high molecular material (see Patent document 1, for example).

However, the high molecular material has a molecular weight distribution and has a disadvantage that purification is difficult. Therefore, an organic EL device obtained by using the high molecular material has problems of a low chromatic purity, a low luminous efficiency and a low luminance.

On the other hand, an emitting layer formed by using a low molecular compound can be produced readily by shorter synthesis route than that of PPV and can be purified to a high purity by a known method such as column chromatography. Therefore, the low molecular compound enables an organic EL device to have advantages of an excellent luminous efficiency, excellent half life of luminance, high chromatic purity and various emission colors.
However, a convenient wet process could not be applied to the low molecular compound since many low molecular compounds have a poor solubility. Therefore, there is desired a wet process which enables to produce a low-molecular type organic EL device having a multilayer structure similarly to a dry process.
[Patent document 1] WO2004/84260

In view of the above problems, an object of the invention is to provide an organic EL device having an emitting layer formed by a wet process using a low molecular luminescent material.

### SUMMARY OF THE INVENTION

As a result of extensive studies on the above-mentioned problems, the inventors have found a low molecular luminescent material soluble in an organic solvent. The inventors have also found that if a layer that is formed before an emitting layer, specifically a hole injecting/transporting layer, is made from a high molecular compound, the two layers can be formed by a wet process.
According to the invention, the following organic EL device is provided.

1. An organic electroluminescent device comprising:
   an anode, a hole injecting/transporting layer, an emitting layer and a cathode stacked in this order;
   the emitting layer being a low molecular emitting layer formed by a wet process using a low molecular luminescent material;
   the hole injecting/transporting layer being a high molecular hole injecting/transporting layer formed by a wet process using a high molecular material.
2. The organic electroluminescent device according to 1 wherein the low molecular luminescent material has a solubility for an organic solvent of 0.5 wt% or more.
3. The organic electroluminescent device according to 1 or 2 wherein the low molecular luminescent material is an asymmetric low molecular compound.

4. The organic electroluminescent device according to 3 wherein the asymmetric low molecular compound is a compound selected from the compounds represented by the following formulas (1) to (3): 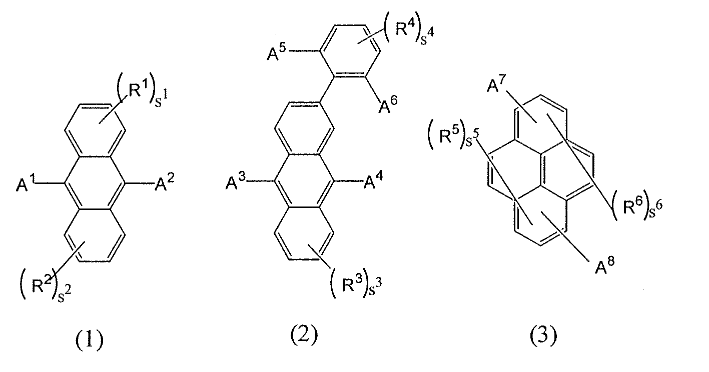 wherein A¹ to A⁵ are an aryl group having 6 to 50 nucleus carbon atoms which may have a substituent or a heteroaryl group having 5 to 50 nucleus atoms which may have a substituent; A⁶ to A⁸ are hydrogen, an aryl group having 6 to 50 nucleus carbon atoms which may have a substituent or a heteroaryl group having 5 to 50 nucleus atoms which may have a substituent; A¹ and A² are not the same as each other; A⁷ and A⁸ are not the same as each other; A³ to A⁶ may be the same or different; R¹ to R⁶ are a substituent; R¹ to R⁶ may be the same or different;
s¹ to s³, s⁵ and s⁶ are an integer of 0 to 4; S¹ to s³, s⁵ and s⁶ may be the same or different; s⁴ is an integer of 0 to 3; and R¹ to R⁶ may be the same or different when s¹ to s⁶ are an integer of 2 or more.

5. The organic electroluminescent device according to any one of 1 to 4 wherein the high molecular material has a weight average molecular weight (Mw) of 50,000 to 300,000.
6. The organic electroluminescent device according to any one of 1 to 5 wherein the high molecular material has a fluorene skeleton.

7. The organic electroluminescent device according to 6 wherein the high molecular material is a compound selected from the compounds represented by the following formulas (4) to (6): 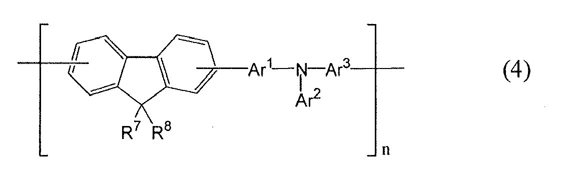 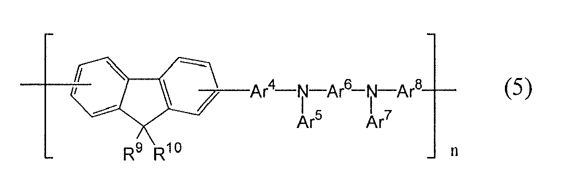 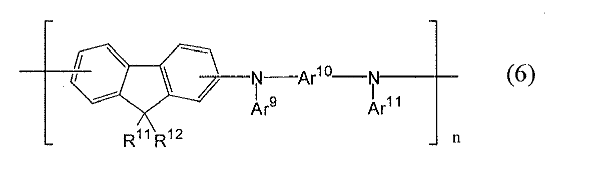 wherein R⁷ to R¹² are a substituent; R⁷ to R¹² may be the same or different; R⁷ to R¹² may be bonded together to form a ring structure; Ar¹, Ar³, Ar⁴, Ar⁶, Ar⁸ and Ar¹⁰ are an arylene group having 6 to 50 nucleus carbon atoms which may have a substituent; Ar², Ar⁵, Ar⁷, Ar⁹ and Ar¹¹ are an aryl group having 6 to 50 nucleus carbon atoms which may have a substituent; and n is an integer.

According to the invention, a hole injecting/transporting layer and an emitting layer can be formed by a wet process. This allows a large organic EL display which can not be realized by a dry process such as vacuum deposition.
The emitting layer is formed by using a low molecular luminescent material, whereby there can be efficiently produced an organic EL device excellent in luminous efficiency, luminance and half lifetime.

### BRIEF DESCRIPTION OF DRAWINGS

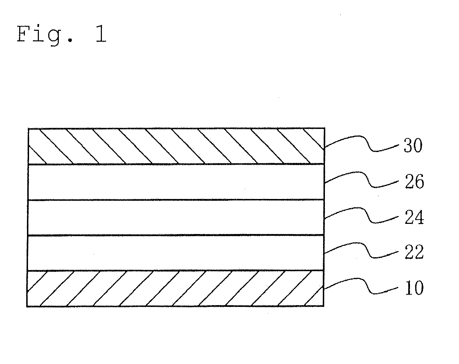

FIG. 1 is a cross-sectional view showing an embodiment of an organic EL device according to the invention.

### BEST MODE FOR CARRYING OUT THE INVENTION

An organic EL device according to the invention is described below in detail.
The organic EL device of the invention comprises an anode, a hole injecting/transporting layer, an emitting layer and a cathode stacked in this order. The emitting layer is a low molecular emitting layer formed by a wet process using a low molecular luminescent material. The hole injecting/transporting layer is a high molecular hole injecting/transporting layer formed by a wet process using a high molecular material.
The hole injecting/transporting layer, which is formed between the anode and the emitting layer, is a layer for helping the injection of holes into the emitting layer to transport the holes to a light emitting region. The hole injecting/transporting layer comprises a monolayer structure or a multilayer structure in which a hole injecting layer and a hole transporting layer are separately stacked. When the hole injecting/transporting layer has a multilayer structure, at least one of the layers constituting the hole injecting/transporting layer is formed by a wet process using a high molecular material.

In the invention, a low molecular luminescent material used for an emitting layer is not limited insofar as the low molecular material is soluble in an organic solvent and can be used for a wet process. The low molecular luminescent material preferably has a solubility for an organic solvent of 0.1 wt% or more. In various device structures, the thickness of an emitting layer in an organic EL device is normally 10 to 100 nm. The common thickness of the emitting layer is 50 nm. When forming a layer with such a thickness by a wet process, it is desired that the luminescent material be dissolved at a concentration of 0.1 wt% or more. If the concentration is less than 0.1 wt%, an organic thin film layer with a sufficient thickness cannot be obtained. In addition, troubles such as lowering of performance and significant divergence of the color tone may occur. A preferred concentration of the coating solution is 0.1 wt% or more. To form a layer with a common thickness of 50 nm, it is preferred that the solution concentration be 0.5 wt% or more.

As such materials, an asymmetric low molecular compound can be used due to high solubility for an organic solvent. In more detail, there can be used the compounds represented by the following formulas (1) to (3):

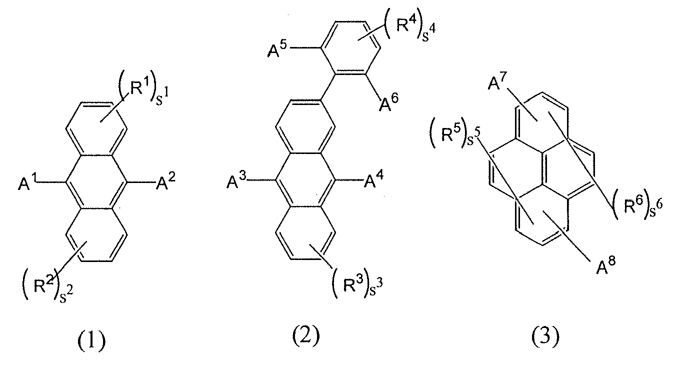

wherein A¹ to A⁵ are an aryl group having 6 to 50 nucleus carbon atoms which may have a substituent or a heteroaryl group having 5 to 50 nucleus atoms which may have a substituent; A⁶ to A⁸ are hydrogen, an aryl group having 6 to 50 nucleus carbon atoms which may have a substituent or a heteroaryl group having 5 to 50 nucleus atoms which may have a substituent; A¹ and A² are not the same as each other; A⁷ and A⁸ are not the same as each other; A³ to A⁶ may be the same or different; R¹ to R⁶ are a substituent; R¹ to R⁶ may be the same or different;
s¹ to s³, s⁵ and s⁶ are an integer of 0 to 4; s¹ to s³, s⁵ and s⁶ may be the same or different; s⁴ is an integer of 0 to 3; and R¹ to R⁶ may be the same or different when s¹ to s⁶ are an integer of 2 or more.

Preferable examples of the aryl group having 6 to 50 nucleus carbon atoms which may have a substituent of A¹ to A⁸ include phenyl, 2-biphenylyl, 3-biphenylyl, 4-biphenylyl, terphenylyl, 2-(1-naphthyl)phenyl, 2-(2-naphthyl)phenyl, 3-(1-naphthyl)phenyl, 3-(2-naphthyl)phenyl, 4-(1-naphthyl)phenyl, 4-(2-naphthyl)phenyl, 3,5-diphenylphenyl, 3,4-diphenylphenyl, 3,5-di(1-naphthyl)phenyl, 3,5-di(2-naphthyl)phenyl, 6-phenylnaphthalene-2-yl, 6-(1-naphthyl)naphthalene-2-yl, 6-(2-naphthyl)naphthalene-2-yl, pentaphenylphenyl, 4-(2,2-diphenylvinyl)phenyl, 4-(1,2,2-triphenylvinyl)phenyl, fluorenyl, 9,9-dimethylfluorenyl, 9,9-dihexylfluorenyl, 9,9-dioctylfluorenyl, 1-naphthyl, 2-naphthyl, 9-anthryl, 2-anthyryl, 9-phenanthryl, 1-pyrenyl, crycenyl, naphthacenyl and cholonyl.

Preferable examples of the heteroaryl group having 5 to 50 nucleus atoms which may have a substituent include furan, thiophene, pyrrole, imidazole, pyrazole, triazole, oxadiazole, pyridine, pyrazine, triazine, benzofuran, dibenzofuran, benzothiophene, dibenzothophene and carbazol.

In the above-mentioned formulas, examples of the substituent of R¹ to R⁶ include an alkyl group such as methyl, ethyl, 1-propyl, 2-propyl, 1-butyl, 2-butyl, sec-butyl, tert-butyl, pentyl, hexyl, 2-ethylhexyl, octyl, decyl, dodecyl, 2-ethylhexyl, 3,7-dimethyloctyl, cyclopropyl, cyclopentyl, cyclohexyl, 1-adamantyl, 2-adamantyl, norbornyl, trifluoromethyl, trichloromethyl, benzyl, α,α-dimethylbenzyl, 2-phenylethyl and 1-phenylethyl; an alkenyl group such as vinyl, propenyl, butenyl, pentenyl, oleyl, eicosapentaenyl, docosahexaenyl, 2,2-diphenylvinyl, 1,2,2-triphenylvinyl and 2-phenyl-2-propenyl; an alkynyl group such as ethinyl, methylethinyl and phenylethinyl; and an alkoxy group such as methoxy, ethoxy, 1-propyloxy, 2-propyloxy, 1-butyloxy, 2-butyloxy, sec-butyloxy, tert-butyloxy, pentyloxy, hexyloxy, octyloxy, decyloxy, dodecyloxy, 2-ethylhexyloxy, 3,7-dimethyloctyloxy, cyclopropyloxy, cyclopentyloxy, cyclohexyloxy, 1-adamantyloxy, 2-adamantyloxy, norbornyloxy, trifluoromethoxy, benziloxy, α,α-dimethylbenziloxy, 2-phenylethoxy and 1-phenylethoxy.
Specific examples of the compounds represented by the formulas (1) to (3) are illustrated below.

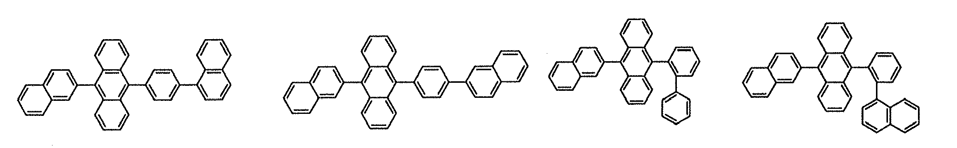

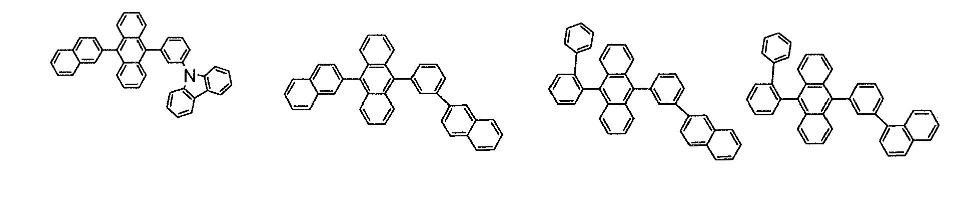

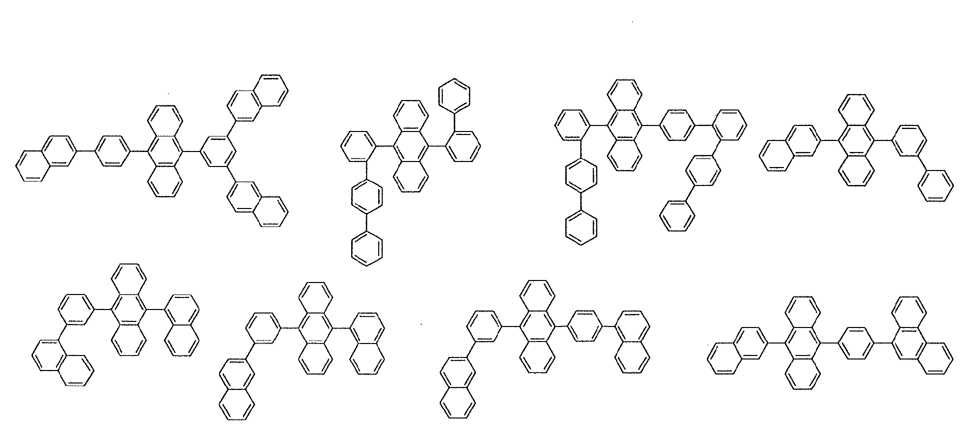

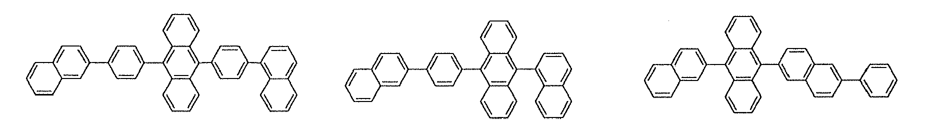

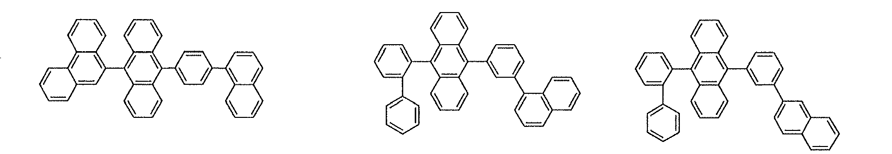

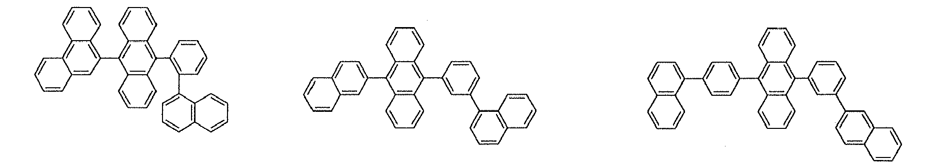

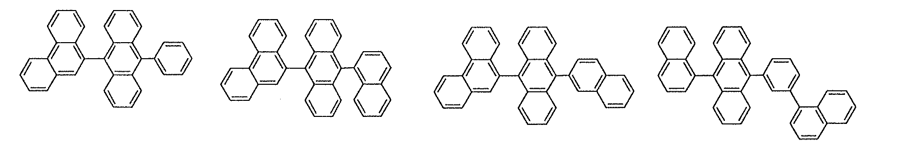

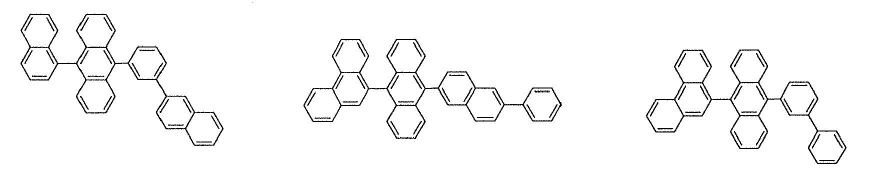

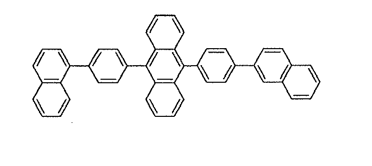

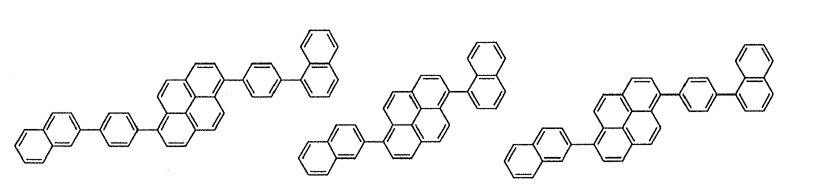

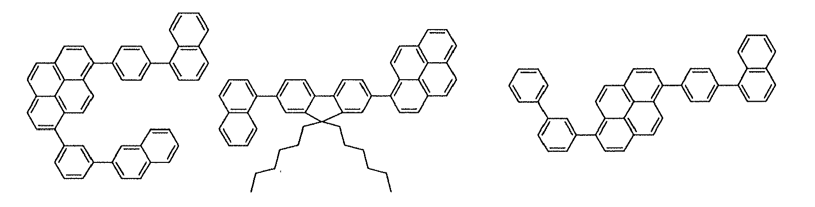

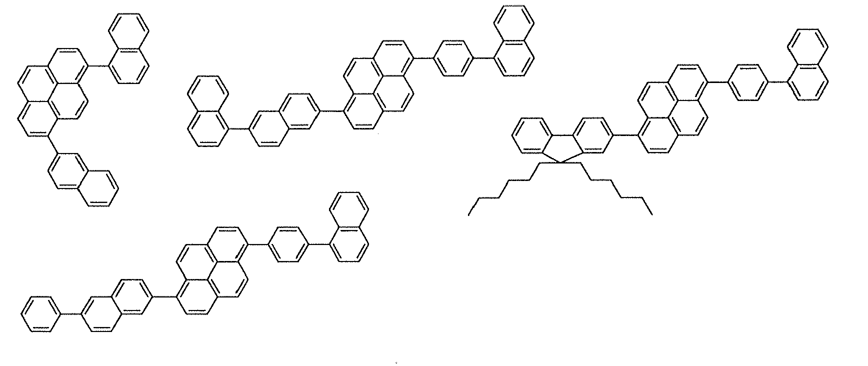

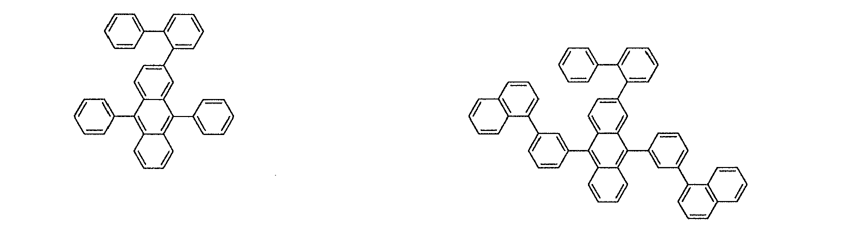

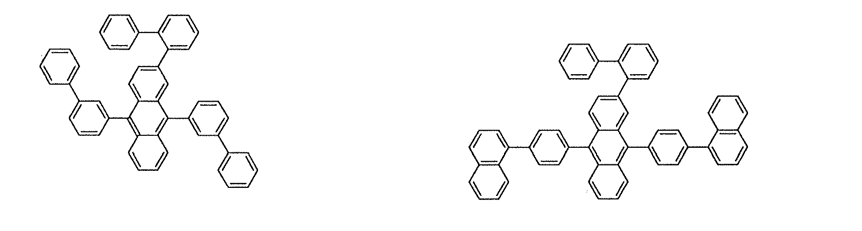

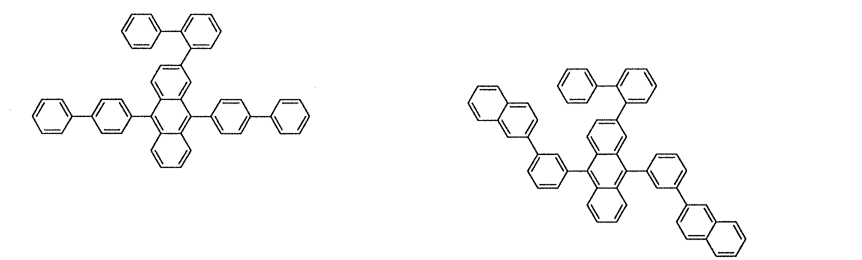

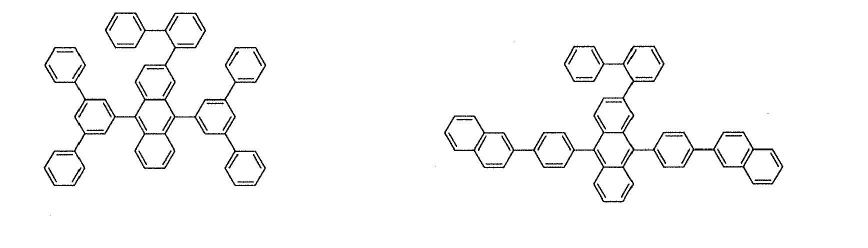

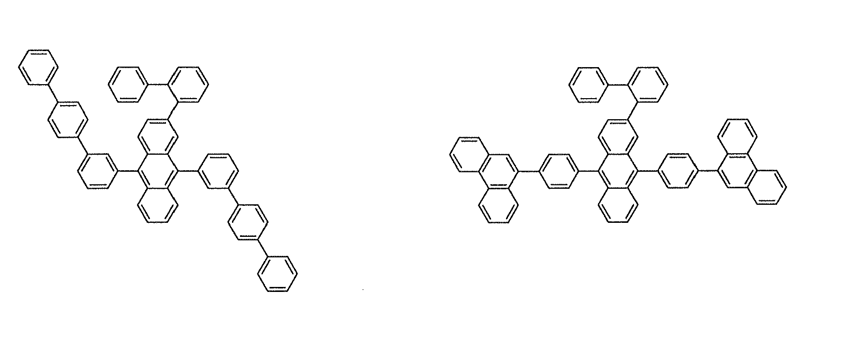

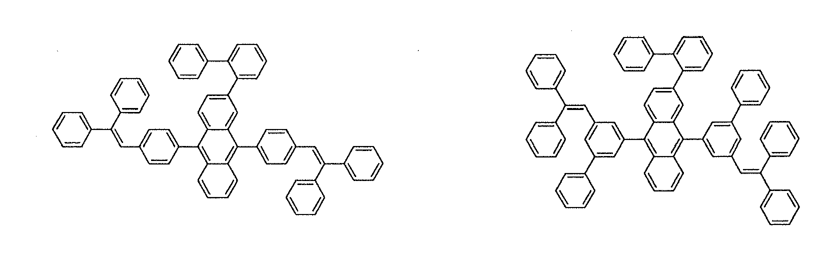

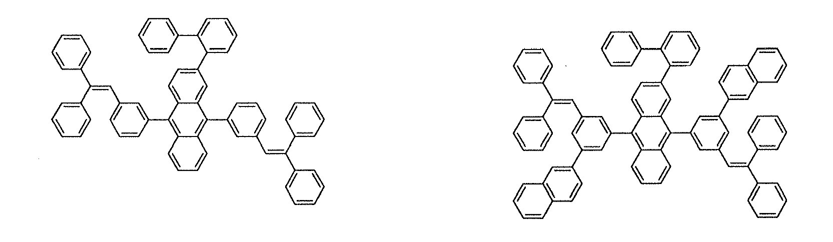

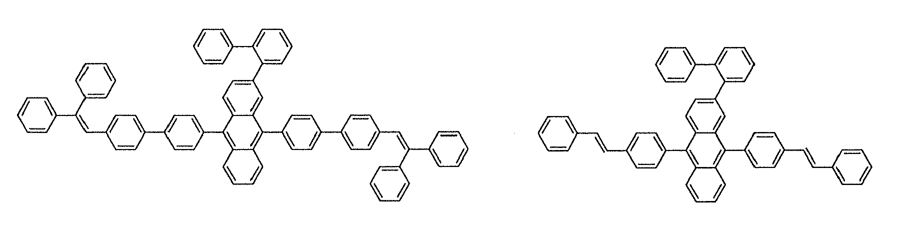

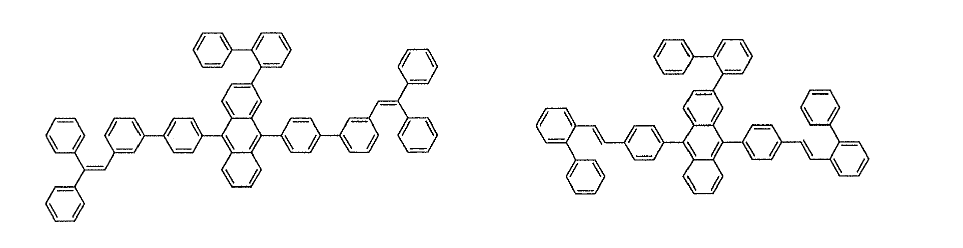

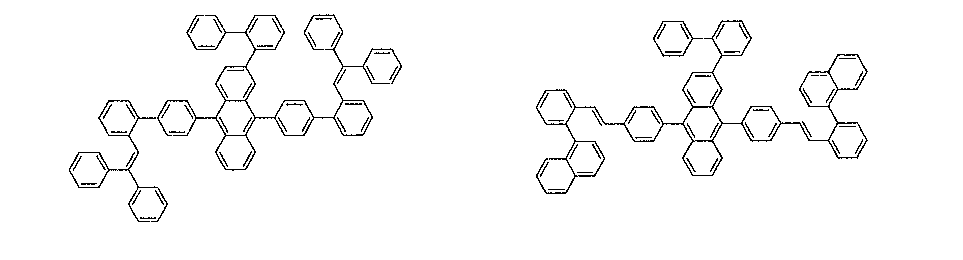

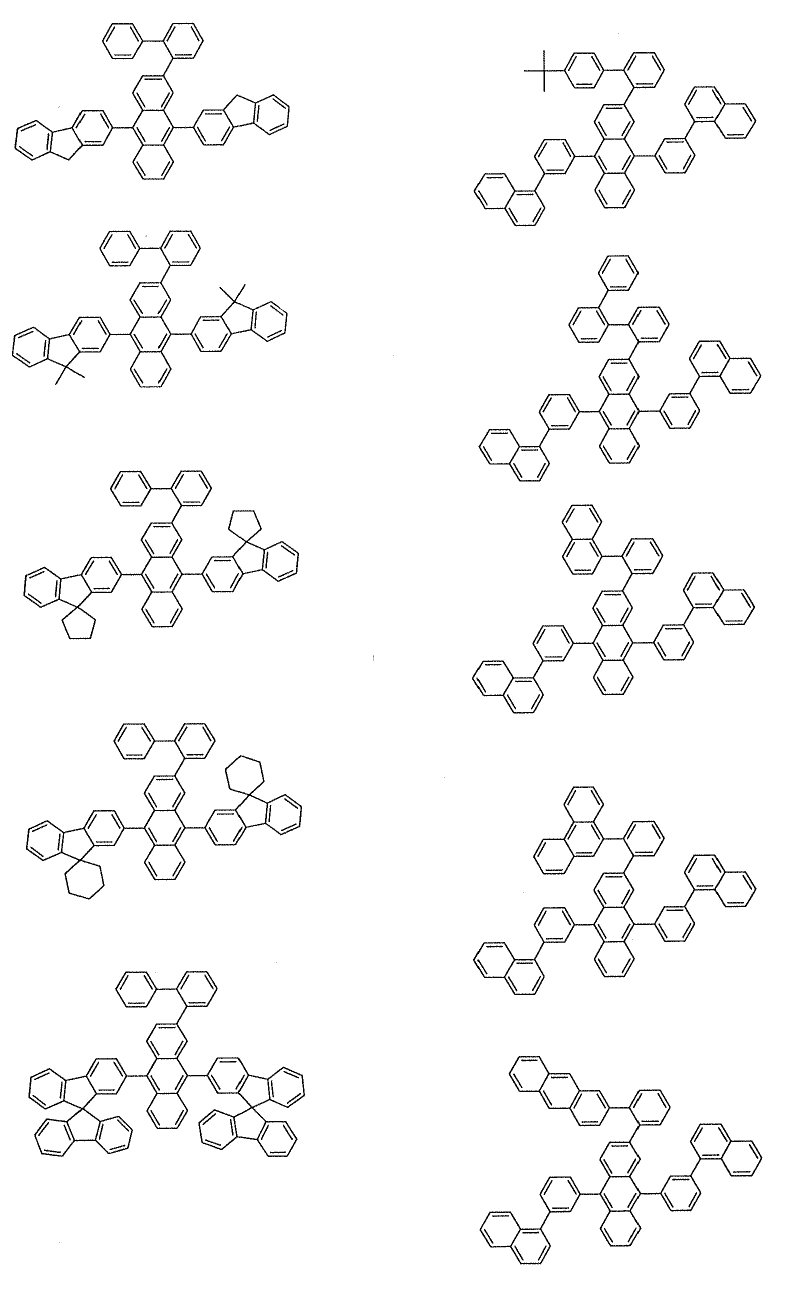

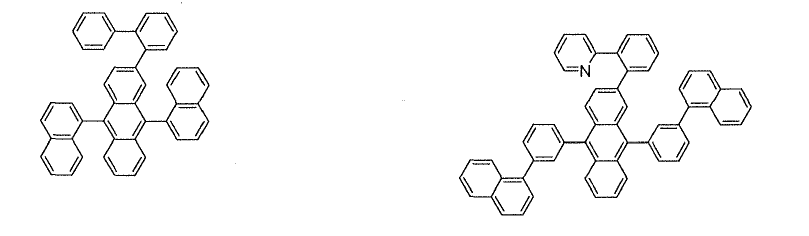

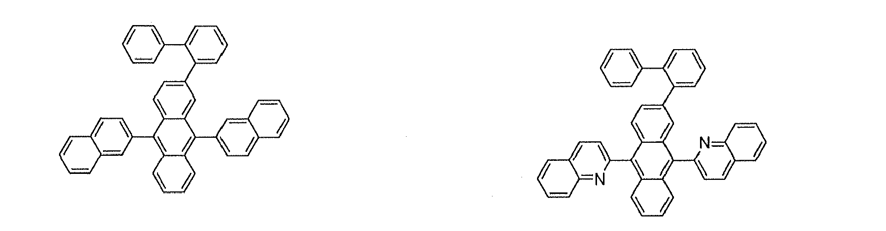

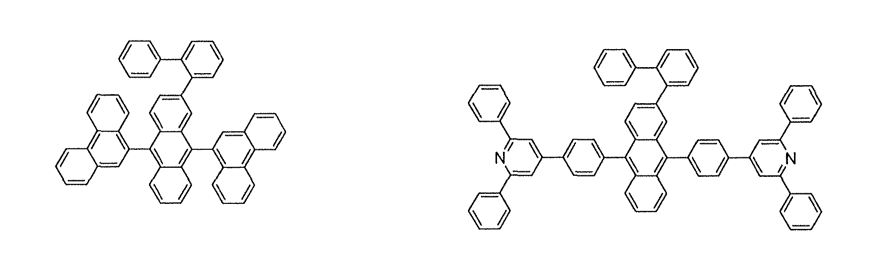

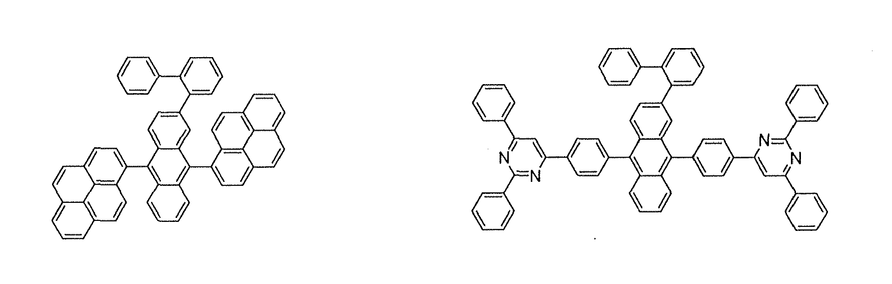

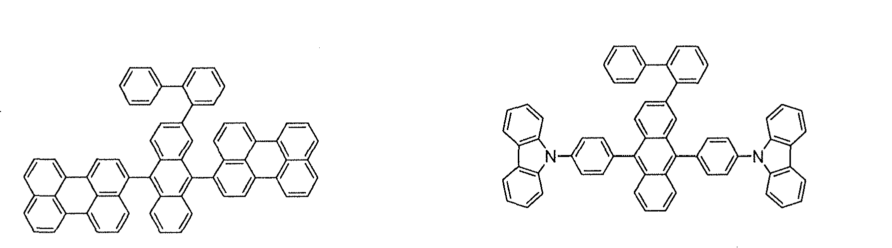

As a high molecular material forming the hole injecting/transporting layer, there can be used an luminescent material soluble for an organic solvent such as polyvinylcarbazol and derivatives thereof, polyfluorene and derivatives thereof, polyaniline and derivatives thereof, polysilane and derivatives thereof, polysiloxane derivatives having an aromatic amine in a main chain or side chain, polythiophene and derivatives thereof, and polypyrrole.

The weight average molecular weight (Mw) of the high molecular material is preferably 50,000 to 300,000, particularly preferably 100,000 to 200,000. When Mw is less than 50,000, the initial performance of the organic EL device may be lowered or the device may be deteriorated due to production of dots in the hole injecting/transporting layer caused by drop out of low molecular components contained in the high molecular material when forming the emitting layer. When Mw is more than 300,000, the layer formation may be difficult due to gelatification of the material.
The weight average molecular weight (Mw) is a value obtained by measuring the weight average molecular weight, which is converted into polystyrene, using tetrahydrofuran as a solvent by gel permeation chromatography (GPC).

In the invention, a high molecular material having a fluorene skeleton is preferably used due to high solubility. Particulary preferred are the high molecular materials represented by the following formulas (4) to (6):

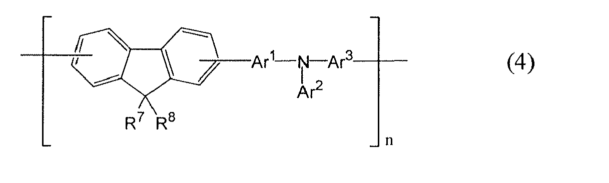

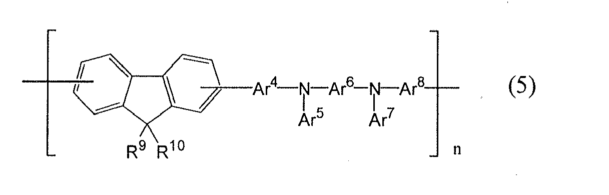

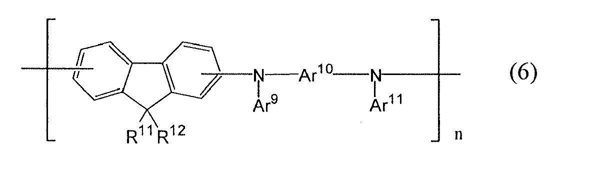

wherein R⁷ to R¹² are a substituent; R⁷ to R¹² may be the same or different; R⁷ to R¹² may be bonded together to form a ring structure; Ar¹, Ar³, Ar⁴, Ar⁶, Ar⁸ and Ar¹⁰ are an arylene group having 6 to 50 nucleus carbon atoms which may have a substituent; Ar², Ar⁵, Ar⁷, Ar⁹ and Ar¹¹ are an aryl group having 6 to 50 nucleus carbon atoms which may have a substituent; and n is an integer.

In the above-mentioned formulas, examples of the substituents of R⁷ to R¹² include an alkyl group such as methyl, ethyl, 1-propyl, 2-propyl, 1-butyl, 2-butyl, sec-butyl, tert-butyl, pentyl, hexyl, 2-ethylhexyl, octyl, decyl, dodecyl, 2-ethylhexyl and 3,7-dimethyloctyl; an alkenyl group such as vinyl, propenyl, butenyl, pentenyl, oleyl, eicosapentaenyl and docosahexaenyl; and an alkoxy group such as methoxy, ethoxy, 1-propyloxy, 2-propyloxy, 1-butyloxy, 2-butyloxy, sec-butyloxy, tert-butyloxy, pentyloxy, hexyloxy, octyloxy, decyloxy, dodecyloxy, 2-ethylhexyloxy and 3,7-dimethyloctyloxy.
The ring strucrtures formed of R⁷ to R¹² include fluorene, cyclopentane, cyclohexane and indan.

In the above-mentioned formulas, preferable examples of the arylene group having 6 to 50 nucleus carbon atoms which may have a substituent of Ar¹, Ar³, Ar⁴, Ar⁶, Ar⁸ and Ar¹⁰ include 1,4-phenylene, 1,3-phenylene, naphthalene-2,6-diyl, naphthalene-1,4-diyl, anthracene-9,10-diyl, biphenyl-4,4'-diyl, and biphenyl-4,3'-diyl.
Examples of the substituent of Ar¹, Ar³, Ar⁴, Ar⁶, Ar⁸ and Ar¹⁰ are the same as those of R¹ to R⁶ mentioned above.

Preferable examples of the aryl group having 6 to 50 nucleus carbon atoms which may have a substituent of Ar², Ar⁵, Ar⁷, Ar⁹ and Ar¹¹ include phenyl, 2-biphenylyl, 3-biphenylyl, 4-biphenylyl, terphenylyl, 3,5-diphenylphenyl, 3,4-diphenylphenyl, 3,5-di(1-naphthyl)phenyl, 3,5-di(2-naphthyl)phenyl, fluorenyl, 1-naphthyl, 2-naphthyl, 9-anthryl, 2-anthryl, 9-phenanthryl, 1-pyrenyl, crycenyl, naphthacenyl, and cholonyl.
Examples of the substituent of Ar², Ar⁵, Ar⁷, Ar⁹ and Ar¹¹ are the same as those of R¹ to R⁶ mentioned above.
Specific examples of the high molecular material are given below.

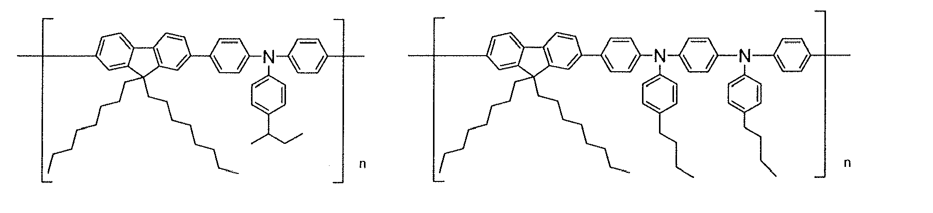

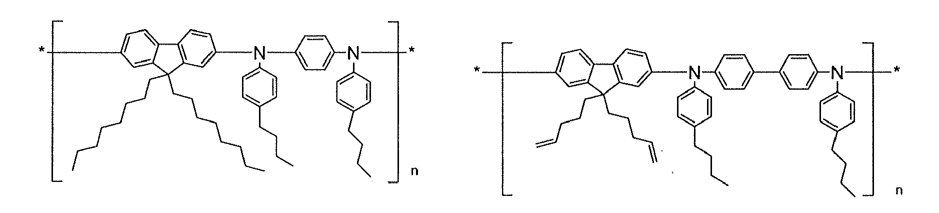

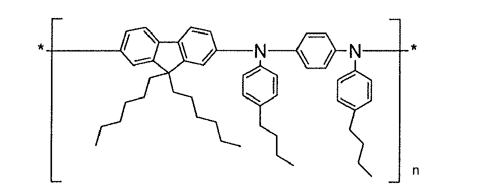

In the invention, the emitting layer and the hole injecting/transporting layer are formed by a wet process using the low molecular luminescent material and the high molecular material mentioned above. Specifically, forming materials of each layer are dissolved in an organic solvent, followed by applying to a forming spot and drying, thereby forming the layers.
Examples of the solvent for dissolving the above-mentioned materials include an alcohol-based solvent such as methanol, ethanol, propanol, isopropanol, n-butanol, t-butanol, pentanol, hexanol, cyclohexanol, methyl cellosolve, ethyl cellosolve, ethylene glycol; a halogenated hydrocarbon-based solvent such as dichloromethane, dichloroethane, chloroform, carbon tetrachloride, tetrachloroethane, trichloroethane, chlorobenzene, dichlorobenzene, and chlorotoluene; an ether-based solvent such as dibutyl ether tetrahydrofuran, dioxane, and anisole; an aromatic solvent such as benzene, toluene, xylene, and ethyl benzene; a paraffin-based solvent such as hexane, octane, decane, and tetralin; an ester-based solvent such as ethyl acetate, butyl acetate, and amyl acetate; an amide-based solvent such as N,N-dimethylformamide, N,N-dimethylacetoamide, and N-methylpyrrolidinone; a ketone-based solvent such as acetone, methyl ethyl ketone, cyclohexanone, and isophorone; an amine-based solvent such as pyridine, quinoline, and aniline; a nitrile-based solvent such as acetonitrile and valeronitrile; and a sulfur-based solvent such as thiophene and carbon disulfide. The usable solvents are not limited to these.

The emitting layer and the hole injecting/transporting layer are formed by a wet process using the solution of materials forming each the layer prepared.
The wet method as referred to herein means a film-forming method in which a solution obtained by dissolving a specific compound in a solvent is used, such as spin coating, inkjet, applying, injecting, spray, dipping coating, screen printing, roll coating, and a LB method.
In the invention, the emitting layer and the hole injecting/transporting layer can be formed by these known methods.

The organic EL device of the invention is required to comprise the emitting layer and the hole injecting/transporting layer mentioned above and my have a known constitution with respect to the other constituent components. An organic EL device according to the invention is described below.

FIG. 1 is a cross-sectional view showing an embodiment of the organic EL device according to the invention.
This organic EL device has a structure where a hole injecting/transporting layer 22, an emitting layer 24 and an electron injecting layer 26 are stacked in this order between an anode 10 and a cathode 30.
As the representative device structure of the organic EL device of the invention, the following structures can be given.
(1) Anode/hole-injecting/transporting layer/emitting layer/cathode
(2) Anode/hole-injecting/transporting layer/emitting layer/electron-injecting layer/cathode (Fig. 1)
(3) Anode/hole-injecting layer/hole-transporting layer/emitting layer/electron-injecting layer/cathode
(4) Anode/insulative layer/hole-injecting layer/hole-transporting layer/emitting layer/insulative layer/cathode
(5) Anode/insulative layer/hole-injecting layer/hole-transporting layer/emitting layer/electron-injecting layer/cathode
   The device structure is, however, not limited to these.
   Of these, normally, the structure (3) is preferably used.

The anode of the organic EL device of the invention plays a role for injecting holes into its hole-transporting layer or emitting layer. The anode effectively has a work function of 4.5 eV or more. Indium tin oxide alloy (ITO), tin oxide (NESA), gold, silver, platinum, copper, and the like may be used as the material for the anode. The cathode is preferably formed of a material having a small work function in order to inject electrons into an electron-transporting layer or emitting layer.
The anode can be formed by forming these electrode materials into a thin film by vapor deposition, sputtering or the like.
In the case where emission from the emitting layer is taken out through the anode, the transmittance of the anode to the emission is preferably more than 10%. The sheet resistance of the anode is preferably several hundreds Ω/□ or less. The film thickness of the anode, which varies depending upon the material thereof, is usually from 10 nm to 1 µm, preferably from 10 to 200 nm.

The hole injecting/transporting layer has above-mentioned functions. The hole mobility thereof is large and the ionization energy thereof is usually as small as 5.5 eV or less. Such a hole-injecting/transporting layer is preferably made of a material which can transport holes to the emitting layer at a lower electric field intensity. The hole mobility thereof is preferably at least 10⁻⁴ cm2/V·second when an electric field of, e.g., 10⁴ to 10⁶ V/cm is applied.

The emitting layer of the organic EL device has the following functions in combination.
(i) Injecting function: function of allowing injection of holes from anode or hole injecting layer and injection of electrons from cathode or electron injecting layer upon application of electric field
(ii) Transporting function: function of moving injected carriers (electrons and holes) by the force of electric field
(iii) Emission function: function of providing a site for recombination of electrons and holes, leading to emission
Note that electrons and holes may be injected into the emitting layer with different degrees, or the transportation capabilities indicated by the mobility of holes and electrons may differ. It is preferable that the emitting layer move either electrons or holes.

In the invention, the content of the low molecular luminescent material of the emitting layer mentioned above is preferably 10 to 100 mol%, more preferably 50 to 99 mol%.
The emitting layer may contain a fluorescent or a phosphorescent dopant.

As the phosphorescent dopant, a styrylamine compound represented by the following formula (7) or an arylamine compound represented by the following formula (8) can be used.

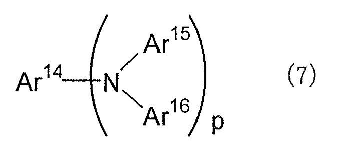

wherein Ar¹⁴ is a group selected from phenyl, biphenyl, terphenyl, stilbene and distyrylaryl, Ar¹⁵ and Ar¹⁶ are independently a hydrogen atom or an aromatic group having 6 to 20 carbon atoms, provided that Ar¹⁴ to Ar¹⁶ may be substituted. p is an integer of 1 to 4. It is more preferable that Ar¹⁵ and/or Ar¹⁶ be substituted with a syryl group.

As the aromatic group having 6 to 20 carbon atoms, phenyl, naphthyl, anthranyl, phenanthryl, and terphenyl are preferable. 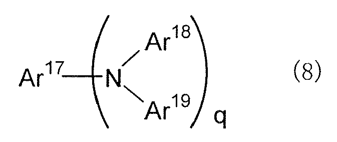 wherein Ar¹⁷ to Ar¹⁹ are a substituted or unsubstituted aryl group having 5 to 40 nucleus atoms. q is an integer of 1 to 4.)

As the aryl group having 5 to 40 nucleus atoms, phenyl, naphthyl, anthranyl, phenanthryl, pyrenyl, cholonyl, biphenyl, terphenyl, pyrolyl, furanyl, thiophenyl, benzthiophenyl, oxadiazolyl, diphenylantranyl, indolyl, carbazolyl, pyridyl, benzoquinolyl, fluoranthenyl, acenapthofluoranthenyl, stilbene, or the like are preferable. The aryl group having 5 to 40 nucleus atoms may be substituted with a substituent. Examples of the preferred substituent include an alkyl group having 1 to 6 carbon atoms (ethyl, methyl, i-propyl, n-propyl, s-butyl, t-butyl, pentyl, hexyl, cyclopentyl, cyclohexyl, or the like); an alkoxy group having 1 to 6 carbon atoms (ethoxy, methoxy, i-propoxy, n-propoxy, s-butoxy, t-butoxy, pentoxy, hexyloxy, cyclopentoxy, cyclohexyloxy, or the like); an aryl group having 5 to 40 nucleus atoms; an amino group substituted with an aryl group having 5 to 40 nucleus atoms; an ester group with an aryl group having 5 to 40 nucleus atoms; an ester group with an alkyl group having 1 to 6 carbon atoms; a cyano group; a nitro group; and a halogen atom (chlorine, bromine, iodine, or the like).

The phosphorous dopant is preferably a metal complex containing at least one metal selected from iridium (Ir), ruthenium (Ru), palladium (Pd), platinum (Pt), osmium (Os) and rhenium (Re). The ligand preferably has at least one skeleton selected from phenylpyridine, bipyridyl, and phenanthroline. Specific examples of such metal complex include, but not limited to, tris(2-phenylpyridine)iridium, tris(2-phenylpyridine)ruthenium, tris(2-phenylpyridine)palladium, bis(2-phenylpyridine)platinum, tris(2-phenylpyridine)osmium, tris(2-phenylpyridine)rhenium, platinum octaethyl porphyrin, platinum octaphenyl porphyrin, palladium octaethyl porphyrin, and palladium octaphenyl porphyrin. A suitable complex is selected according to a required color of emitted light, device performance, and a relationship with a host compound.

The emitting layer may also be formed by dissolving a binder such as a resin and the above-mentioned low molecular luminescent material in a solvent to obtain a solution, and forming a thin film from the solution by spin coating or the like, as disclosed in JP-A-57-51781.
If desired, the emitting layer of the invention may contain an other known luminescent material insofar as the object of the invention is not impaired. Alternatively, the emitting layer of the invention and another emitting layer containing a known luminescent material may be stacked.

For the cathode, the following may be used: an electrode substance made of a metal, an alloy or an electroconductive compound, or a mixture thereof which has a small work function (4 eV or less). Specific examples of the electrode substance include sodium, sodium-potassium alloy, magnesium, lithium, magnesium/silver alloy, aluminum/aluminum oxide, aluminum/lithium alloy, indium, and rare earth metals.
This cathode can be formed by making the electrode substances into a thin film by vapor deposition, sputtering or some other method. In the case where emission from the emitting layer is taken out through the cathode, it is preferred to make the transmittance of the cathode to the emission larger than 10%. The sheet resistance of the cathode is preferably several hundreds Ω/□ or less, and the film thickness thereof is usually from 10 nm to 1 µm, preferably from 50 to 200 nm.

Usually, an organic EL device is formed on a transparent substrate. The transparent substrate is a substrate for supporting the organic EL device, and is preferably a flat and smooth substrate having a transmittance of 50% or more to light rays within visible ranges of 400 to 700 nm.
Specific examples thereof include glass plates and polymer plates. Examples of the glass plate include soda-lime glass, barium/strontium-containing glass, lead glass, aluminosilicate glass, borosilicate glass, barium borosilicate glass, and quartz. Examples of the polymer plate include polycarbonate, acrylic polymer, polyethylene terephthalate, polyethersulfide, and polysulfone.

In the organic EL device of the invention, an organic semiconductive layer, electron injecting layer, insulative layer and the like may be formed, if necessary.
The organic semiconductor layer is formed between an anode and an emitting layer, and is a layer for helping the injection of holes or electrons into the emitting layer, and is preferably a layer having an electric conductivity of 10⁻¹⁰ S/cm or more. As the material of such an organic semiconductor layer, electroconductive oligomers such as thiophene-containing oligomers or arylamine-containing oligomers disclosed in JP-A-8-193191, and electroconductive dendrimers such as arylamine-containing dendrimers may be used.

The electron-injecting layer is a layer which assists injection of electrons into the emitting layer, and exhibits a high electron mobility. An adhesion-improving layer is formed of a material which exhibits excellent adhesion to the cathode among such electron-injecting layers. The material used in the electron-injecting layer is preferably a metal complex of 8-hydroxyquinoline or a derivative thereof, or an oxadiazole derivative.

As specific examples of a metal complex of 8-hydroxyquinoline and an 8-hydroxyquinoline derivative, metal chelate oxinoid compounds including a chelate of oxine (usually, 8-quinolinol or 8-hydroxyquinoline) can be given. For example, tris(8-quinolinol)aluminum (Alq) may be used in the electron-injecting layer.
An electron transporting compound of the following general formula can be given as the oxadiazole derivative.

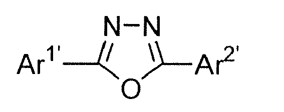

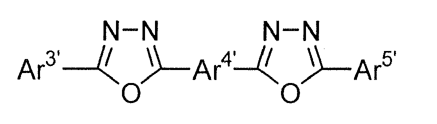

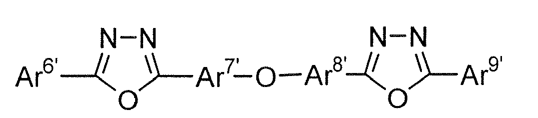

wherein Ar^{1'}, Ar^{2'}, Ar^{3'}, Ar^{5'}, Ar^{6'} and Ar^{9'} each represent a substituted or unsubstituted aryl group and may be the same or different, and Ar^{4'}, Ar^{7'} and Ar^{8'} represent a substituted or unsubstituted arylene group and may be the same or different.
As examples of the aryl group, a phenyl group, a biphenyl group, an anthranyl group, a perylenyl group, and a pyrenyl group can be given. As examples of the arylene group, a phenylene group, a naphthylene group, a biphenylene group, an anthranylene group, a perylenylene group, a pyrenylene group, and the like can be given. As the substituent, an alkyl group having 1 to 10 carbon atoms, an alkoxy group having 1 to 10 carbon atoms, a cyano group, or the like can be given. The electron-transporting compound is preferably one from which a thin film can be formed.

The following compounds can be given as specific examples of the electron transporting compound. 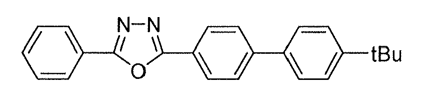 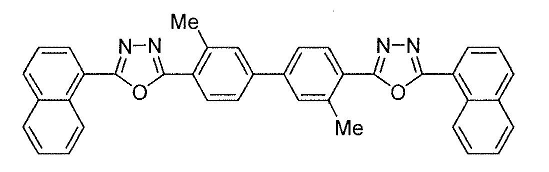 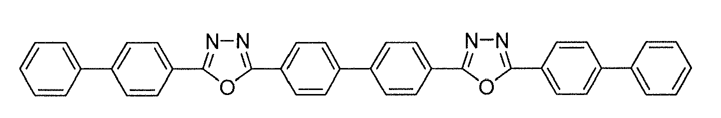 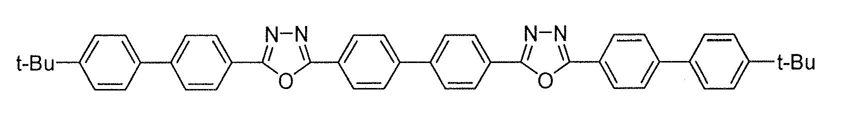 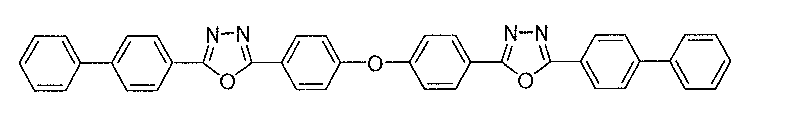 wherein Me is a methyl group, and Bu is a butyl group.

A preferred embodiment of the invention is a device containing a reducing dopant in an interfacial region between its electron transferring region or cathode and organic layer. The reducing dopant is defined as a substance which can reduce an electron transferring compound. Accordingly, various substances which have certain reducing properties can be used. For example, at least one substance can be preferably used which is selected from the group consisting of alkali metals, alkaline earth metals, rare earth metals, alkali metal oxides, alkali metal halides, alkaline earth metal oxides, alkaline earth metal halides, rare earth metal oxides, rare earth metal halides, alkali metal organic complexes, alkaline earth metal organic complexes, and rare earth metal organic complexes.

More specifically, preferable reducing dopant include at least one alkali metal selected from Na (work function: 2.36 eV), K (work function: 2.28 eV), Rb (work funciton: 2.16 eV) and Cs (work function 1.95 eV); and at least one alkaline earth metal selected from Ca (work function: 2.9 eV), Sr (work function: 2.0 to 2.5 eV) and Ba (work function: 2.52 eV). A substance having work function of 2.9 eV or less is particularly preferable.

Among these, a more preferable reducing dopant is at least one alkali metal selected from the group consisting of K, Rb and Cs. Even more preferable is Rb or Cs. Most preferable is Cs. These alkali metals are particularly high in reducing ability. Thus, the addition of a relatively small amount thereof to an electron injecting zone improves the luminance of the organic EL device and make the lifetime thereof long. As the reducing dopant having a work function of 2.9 eV or less, a combination of two or more out of these alkali metals is also preferred. Particularly preferred is a combination containing Cs, for example, combinations of Cs and Na, Cs and K, Cs and Rb, or Cs, Na and K. The combination containing Cs makes it possible to exhibit the reducing ability efficiently. The luminance of the organic EL device can be improved and the lifetime thereof can be made long by the addition thereof to its electron-injecting zone.

In the organic EL device, an electron-injecting layer made of an insulator or a semiconductor may further be provided between a cathode and an organic layer. By providing the layer, current leakage can be effectively prevented to improve the injection of electrons.
As the insulator, at least one metal compound selected from the group consisting of alkali metal calcogenides, alkaline earth metal calcogenides, halides of alkali metals and halides of alkaline earth metals can be preferably used. When the electron-injecting layer is formed of the alkali metal calcogenide or the like, the injection of electrons can be preferably further improved. Specifically preferable alkali metal calcogenides include Li₂O, LiO, Na₂S, Na₂Se and NaO and preferable alkaline earth metal calcogenides include CaO, BaO, SrO, BeO, BaS and CaSe. Preferable halides of alkali metals include LiF, NaF, KF, LiCl, KCl and NaCl. Preferable halides of alkaline earth metals include fluorides such as CaF₂, BaF₂, SrF₂, MgF₂ and BeF₂ and halides other than fluorides.

Examples of the semiconductor include oxides, nitrides or oxynitrides containing at least one element selected from Ba, Ca, Sr, Yb, Al, Ga, In, Li, Na, Cd, Mg, Si, Ta, Sb and Zn, and combinations of two or more thereof. An inorganic compound forming an electron transporting layer is preferably a microcrystalline or amorphous insulating thin film. When the electron transporting layer is formed of the insulating thin films, more uniformed thin film is formed whereby pixel defects such as a dark spot are decreased. Examples of such an inorganic compound include the above-mentioned alkali metal calcogenides, alkaline earth metal calcogenides, halides of alkali metals, and halides of alkaline earth metals.

In the organic EL device, pixel defects based on leakage or a short circuit are easily generated since an electric field is applied to the super thin film. In order to prevent this, an insulative layer is formed. Specifically, it is preferred to insert an insulative thin layer between the pair of electrodes.
Examples of the material used in the insulative layer include aluminum oxide, lithium fluoride, lithium oxide, cesium fluoride, cesium oxide, magnesium oxide, magnesium fluoride, calcium oxide, calcium fluoride, aluminum nitride, titanium oxide, silicon oxide, germanium oxide, silicon nitride, boron nitride, molybdenum oxide, ruthenium oxide, and vanadium oxide. A mixture or laminate thereof may be used.

The film thickness of each of the layers in the organic EL device of the invention is not particularly limited. In general, defects such as pinholes are easily generated when the film thickness is too small. Conversely, when the film thickness is too large, a high applied voltage becomes necessary, leading to low efficiency. Usually, the film thickness is preferably in the range of several nanometers to one micrometer.

The organic EL device can be fabricated by forming an anode, a hole-injecting/transporting layer, an emitting layer, optionally forming an electron-injecting layer if necessary, and further forming a cathode by use of the materials and methods exemplified above. The organic EL device can be fabricated in the order reverse to the above, i.e., the order from a cathode to an anode.

### EXAMPLES

### Example 1

A grass substrate of 25 mm by 75 mm by 1.1 mm thick with an ITO transparent electrode (GEOMATEC CO., LTD.) was subjected to ultrasonic cleaning with isopropyl alcohol for 5 minutes, and cleaned with ultraviolet rays and ozone for 30 minutes.
A hole injecting/transporting layer having a multilayer structure was formed on this substrate. Firstly, a 100 nm thick film of polyethylene dioxythiophene/polystyrenesulfonic acid (PEDOT/PSS) was formed by spin coating. Subsequently, a toluene solution containing 0.6 wt% of the polymer 1 (Mw:145,000) shown below was formed into a 20 nm thick film by spin coating, followed by drying at 170°C for 30 minutes.

Next, an emitting layer was formed by spin coating using a toluene solution containing 1 wt% of the compound A and the compound B shown below (compound A:compound B = 20:2 (wt/wt)). The film thickness was 50 nm.
As an electron-transporting layer, a 10-nm thick tris(8-quinolinol)aluminum film (Alq₃ film) was formed thereon. This Alg film functioned as an electron-transporting layer.
Then, Li as a reducing dopant (Li source:
manufactured by SAES Getters Co., Ltd.) and Alq were codeposited, whereby an Alq:Li film was formed as an electron-injecting layer (cathode). Metal Al was deposited thereon as a metal cathode, thereby fabricating an organic EL device.
The device emitted blue light and the emitting surface was uniform. The luminous efficiency was 5.2 cd/A.

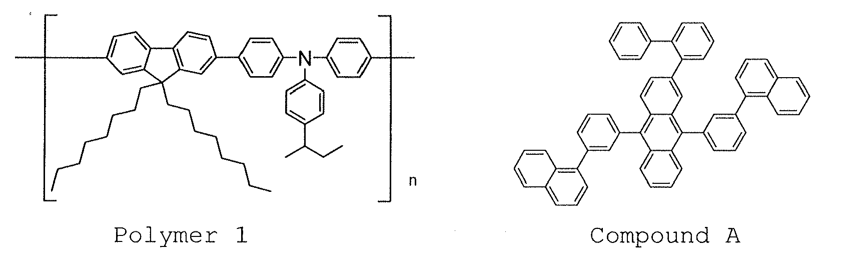

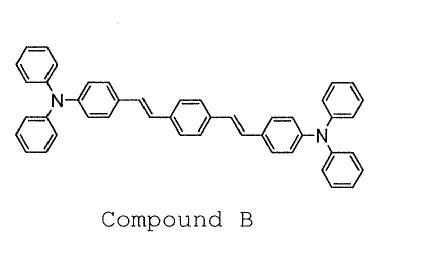

### INDUSTRIAL APPLICABILITY

The organic EL device of the invention can be suitably used as a planar emitting body such as a flat panel display, backlight of a copier, a printer, or a liquid crystal display, light sources for instruments, a display panel, a navigation light, and the like.

## Claims

1. An organic electroluminescent device comprising:
an anode, a hole injecting/transporting layer, an emitting layer and a cathode stacked in this order;
the emitting layer being a low molecular emitting layer formed by a wet process using a low molecular luminescent material;
the hole injecting/transporting layer being a high molecular hole injecting/transporting layer formed by a wet process using a high molecular material.

2. The organic electroluminescent device according to claim 1 wherein the low molecular luminescent material has a solubility for an organic solvent of 0.5 wt% or more.

3. The organic electroluminescent device according to claim 1 or 2 wherein the low molecular luminescent material is an asymmetric low molecular compound.

4. The organic electroluminescent device according to claim 3 wherein the asymmetric low molecular compound is a compound selected from the compounds represented by the following formulas (1) to (3): 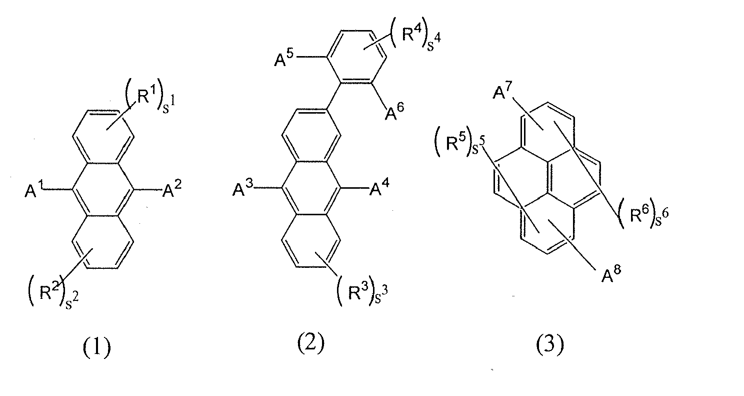 wherein A¹ to A⁵ are an aryl group having 6 to 50 nucleus carbon atoms which may have a substituent or a heteroaryl group having 5 to 50 nucleus atoms which may have a substituent; A⁶ to A⁸ are hydrogen, an aryl group having 6 to 50 nucleus carbon atoms which may have a substituent or a heteroaryl group having 5 to 50 nucleus atoms which may have a substituent; A¹ and A² are not the same as each other; A⁷ and A⁸ are not the same as each other; A³ to A⁶ may be the same or different; R¹ to R⁶ are a substituent; R¹ to R⁶ may be the same or different;
s¹ to s³, s⁵ and s⁶ are an integer of 0 to 4; s¹ to s³, s⁵ and s⁶ may be the same or different; s⁴ is an integer of 0 to 3; and R¹ to R⁶ may be the same or different when s¹ to s⁶ are an integer of 2 or more.

5. The organic electroluminescent device according to any one of claims 1 to 4 wherein the high molecular material has a weight average molecular weight (Mw) of 50,000 to 300,000.

6. The organic electroluminescent device according to any one of claims 1 to 5 wherein the high molecular material has a fluorene skeleton.

7. The organic electroluminescent device according to claim 6 wherein the high molecular material is a compound selected from the compounds represented by the following formulas (4) to (6): 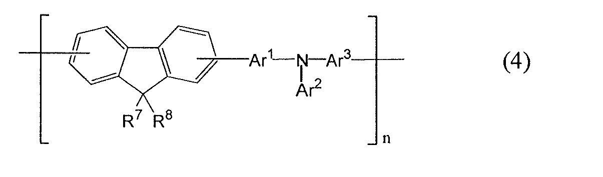 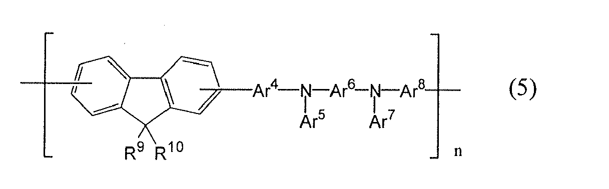 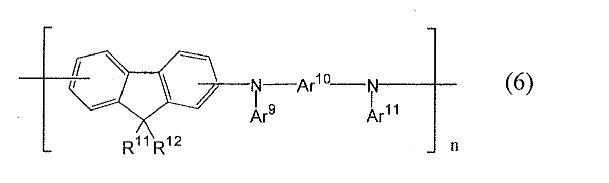 wherein R⁷ to R¹² are a substituent; R⁷ to R¹² may be the same or different; R⁷ to R¹² may be bonded together to form a ring structure; Ar¹, Ar³, Ar⁴, Ar⁶, Ar⁸ and Ar¹⁰ are an arylene group having 6 to 50 nucleus carbon atoms which may have a substituent; Ar², Ar⁵, Ar⁷, Ar⁹ and Ar¹¹ are an aryl group having 6 to 50 nucleus carbon atoms which may have a substituent; and n is an integer.
